# EUROPEAN PATENT APPLICATION

(11) **EP 4 529 386 A1**
(43) Date of publication of application: **26.03.2025**
(21) Application number: 24198191.9
(22) Date of filing: 03.09.2024
(51) Int. Cl.: H10D 30/66, H10D 62/10, H10D 62/17

(54) **A POWER SEMICONDUCTOR DEVICE AND A POWER CONVERTER INCLUDING THE SAME**

(30) Priority: 19.09.2023 KR 20230124502
(71) Applicant: LX Semicon Co., Ltd., Daejeon 34027 (KR)
(72) Inventor: LEE, Ho Jung, 34027 Daejeon (KR); KANG, Nam Ju, 34027 Daejeon (KR); KIM, Dong Kyun, 34027 Daejeon (KR); HONG, Kuk Tae, 34027 Daejeon (KR); HWANG, Jun Ha, 34027 Daejeon (KR)
(74) Representative: Ter Meer Steinmeister & Partner

(57) **Abstract**

A power semiconductor device according to the embodiment can include a substrate, a first epi layer of a first conductivity type disposed on the substrate, a second epi layer of a first conductivity type disposed on the first epi layer of the first conductivity type, a first well of a second conductivity type partially disposed in the first epi layer of the first conductivity type, a second well of a second conductivity type disposed on the second epi layer of the first conductivity type, an ion implantation region and a source region of the second conductivity type disposed in the second well of the second conductivity type, a source electrode disposed on the source region, a gate insulating layer disposed in a trench region in which a portion of the ion implantation region of the second conductivity type and the second epi layer of the first conductivity type is removed, a trench gate disposed on the gate insulating layer, an interlayer insulating layer disposed on the trench gate and a gate electrode electrically connected to the trench gate.

## Description

### TECHNICAL FIELD

The embodiment relates to a power semiconductor device, a power semiconductor module, a power converter, and a method of manufacturing the same.

### BACKGROUND

Power semiconductors are one of the key elements that determine the efficiency, speed, durability, and reliability of power electronic systems.

With the recent development of the power electronics industry, the previously used silicon (Si) power semiconductors have reached their physical limits. Research is being actively conducted on WBG (wide bandgap) power semiconductors such as silicon carbide (SiC) and gallium nitride (GaN) to replace silicon power semiconductors.

WBG power semiconductor devices have a band gap energy that is approximately three times that of Si power semiconductor devices, due to this, it has the characteristics of low intrinsic carrier concentration, high breakdown electric field (about 4 to 20 times), high thermal conductivity (about 3 to 13 times), and large electron saturation rate (about 2 to 2.5 times).

These characteristics enable operation in high temperature and high voltage environments and have high switching speed and low switching loss. Among these, gallium nitride (GaN) power semiconductor devices can be used in low-voltage systems, and silicon carbide (SiC) power semiconductor devices can be suitable for high-voltage systems.

SiC MOSFET power semiconductors of the prior art are generally denoted as VDMOSFETs with a vertical diffused structure, and can also be simply denoted as double-diffused structure DMOSFETs. Additionally, SiC MOSFETs can be classified into Planar MOSFETs and Trench MOSFETs depending on the direction of the channel.

Among these, Trench MOSFET is a structure in which a channel is disposed on the sidewall of the trench. For this, a gate insulating film is disposed on the sidewall of the trench and a gate electrode is disposed in the trench.

Since SiC MOSFETs have high on-resistance due to low channel mobility and large channel resistance, trench MOSFETs were proposed to reduce the channel resistance. Trench MOSFET has the advantage of increasing channel density by forming channels on the sidewalls of the trench.

However, as the trench MOSFET has a larger electric field in the trench gate oxide, which has a shorter drift distance than the P-base (P-well), and in particular, the electric field is concentrated at the trench edge, there is a problem in that gate oxide breakdown occurs quickly and BV decreases.

For example, in the case of SiC Trench MOSFETs, the breakdown field strength is 10 times that of silicon (Si), so SiC semiconductor devices are used with a voltage close to 10 times that of Si devices. For this reason, an electric field 10 times stronger than that of the silicon device is applied to the gate insulating film disposed in the trench, causing a problem in which the gate insulating film is easily destroyed at the corners of the trench.

Internal technology is researching a process to form a p-type well (P-base) deeper than the gate trench to prevent electric field concentration at the corner of the trench, but in order to form such a deep p-type well, there is a problem in that the ion implantation energy exceeds the level of a general process. In addition, high-energy ion implantation causes severe ion implantation outside the target region, which causes a problem of cell pitch reduction due to difficulty in controlling lateral straggling.

### SUMMARY

One of the technical objects of the present disclosure is to provide a power semiconductor device, a power converter including the same, and a manufacturing method of the power semiconductor device to prevent electric field concentration at the corner of the trench while preventing cell from lateral straggling and also to prevent the problem of cell pitch reduction.

At least one of the technical objects is solved by the features of the independent claim. The technical problems of the embodiments are not limited to those described in this item and include those that can be understood through the description of the invention.

A power semiconductor device according to an embodiment may include a substrate 111, a first epi layer 112a of a first conductivity type disposed on the substrate 111, a second epi layer 112b of a first conductivity type disposed on the layer 112a, a first well 121a of a second conductivity type partially disposed in the first epi layer 112a of the first conductivity type, a second well 121b of a second conductivity type disposed in the second epi layer 112b of the first conductivity type, an ion implantation region 122 of a second conductivity type disposed in the second well 121b of the second conductivity type and a source region 115, a source electrode 142 disposed on the source region 115, a gate insulating layer 131 disposed in a trench region (T) in which a portion of the ion implantation region 122 of the second conductivity type and a second epi layer 112b of first conductivity type are removed, a trench gate 132 disposed on the gate insulating layer 131, and an interlayer insulating layer 150 disposed on the trench gate 132 and a gate electrode electrically connected to the trench gate 132.

A side of the first well 121a of the second conductivity type and a side of the second well 121b of the second conductivity type may be aligned upward on the substrate.

A doping concentration of the first well of the second conductivity type disposed in the first epi layer of the first conductivity type may be different from the doping concentration of the second well of the second conductivity type disposed in the second epi layer of the first conductivity type each other.

A doping concentration of the first well of the second conductivity type disposed in the first epi layer of the first conductivity type may be higher than the doping concentration of the second well of the second conductivity type disposed in the second epi layer of the first conductivity type.

The doping concentration of the first well of the second conductivity type formed below the trench gate may have a concentration gradient that changes abruptly than the doping concentration of the second well of the second conductivity type formed adjacent to the trench gate.

The doping concentration of the first well of the second conductivity type may be 2×10¹⁷ to 2×10¹⁹/cm³, and/or the doping concentration of the second well of the second conductivity type may be 1×10¹⁶ to 1×10¹⁷/cm³.

An interface may be formed between the first well of the second conductivity type disposed in the first epi layer 112a of the first conductivity type and the second well 121b of the second conductivity type.

The interface between the first well of the second conductivity type and the second well of the second conductivity type may be disposed at substantially the same position as the lower side of the trench gate.

A first distance between the first wells of the second conductivity type disposed in the first epi layer of the first conductivity type may be different a second distance between the second wells of the second conductivity type disposed in the second epi layer of the first conductivity type.

The first distance D1 between the first wells of the second conductivity type disposed on the first epi layer 112a of the first conductivity type may be longer than the second distance D2 between the second wells 121b of the second conductivity type disposed in the second epi layer 112b of the first conductivity type.

A portion of the lower edge of the second well of the second conductivity type may not overlap top and bottom with the first well of the second conductivity type.

The first well of the second conductivity type may be disposed below the trench gate, and/or the second well of the second conductivity type may be disposed in a horizontal position of the trench gate.

A depth of the second well of the second conductivity type may be different from a depth of the first well of the second conductivity type. The depth of the second well of the second conductivity type may be lower than the depth of the first well.

Additionally, a power converter according to an embodiment may include the power semiconductor device according to any of the herein described embodiments.

In addition, according to an embodiment, a method of manufacturing a power semiconductor device, e.g. the power semiconductor device according to any one of the herein described embodiments, may include growing a first epi layer 112a of a first conductivity type on a substrate 111, partially forming a first well 121a of a second conductivity type by implanting ions into the first epi layer 112a of the first conductivity type, growing a second epitaxial layer (112b) of a first conductivity type on the first epitaxial layer (112a) of the first conductivity type, partially forming a second well (121b) of the second conductivity type by implanting ions into the second epi layer (112b) of the first conductivity type, forming an ion implantation region 122 of a second conductivity type and a source region 115 in the second well 121b of the second conductivity type, forming a trench region (T) by removing a portion of the ion implantation region 122 of the second conductivity type and the second epi layer 112b of the first conductivity type, forming a gate insulating layer 131 and a trench gate 132 in the trench region, forming an interlayer insulating layer 150 on the trench gate 132; and forming a gate electrode electrically connected to the trench gate 132.

The side surface of the first well 121a of the second conductivity type and the side surface of the second well 121b of the second conductivity type may be aligned upward on the substrate.

The doping concentration of the first well 121a of the second conductivity type disposed on the first epi layer 112a of the first conductivity type may be higher than that of the second well 121b of the second conductivity type disposed on the second epi layer 112b of the first conductivity type.

The first distance D1 between the first wells of the second conductivity type disposed on the first epi layer 112a of the first conductivity type may be longer than the second distance D2 between the second wells 121b of the second conductivity type disposed on the second epi layer 112b of first conductivity type.

### [Effects of the Invention]

According to the power semiconductor device, the power converter including the same, and the manufacturing method of the power semiconductor device according to the embodiment, there are technical effects in that the problem of pitch reduction due to lateral straggling can be prevented while preventing electric field concentration at the corner of the trench.

For example, the power semiconductor device 100 according to the embodiment can form the second conductivity type well 121 without using high-energy ion implantation. Accordingly, the problem of pitch reduction due to lateral straggling of the dopant can be prevented, and the second well 121b of the second conductivity type can be disposed in a region deeper than the trench. As a result, the embodiment enables dispersion of the electric field concentrated at the bottom corner of the gate trench, which has the technical effect of preventing destruction of the gate insulating layer.

Also, according to the embodiment, the doping concentration of the first well 121a of the second conductivity type formed below the trench gate 132 may be formed to be higher than the doping concentration of the second well 121b of the second conductivity type. Accordingly, since the depletion layer is expanded in the direction of the substrate 111, there is a technical effect of increasing the breakdown voltage. In addition, according to the embodiment, the doping concentration of the second well 121b of the second conductivity type formed around the trench gate 132 is lower than the doping concentration of the first well 121a of the second conductivity type, so that there is a complex technical effect of decreasing the threshold voltage and increasing current density.

Also, according to the second embodiment, the first distance D1 between the third wells 121c of the second conductivity type disposed on the first epi layer 112a of the first conductivity type may be longer than the second distance D2 between the second wells 121b of the second conductivity type disposed in the second epi layer 112b of the first conductivity type.

Also, according to the second embodiment, the first distance D1 between the third wells 121c of the second conductivity type disposed on the lower side of the trench gate 132 can be controlled to be longer than the second distance D2 between the second wells 121b of the second conductivity type formed around the trench gate 132. Accordingly, there is a special technical effect of reducing Ron by widening the movement range of electrons.

The technical effects of the embodiments are not limited to those described in this item and include those that can be understood through the description of the invention.

### BRIEF DESCRIPTION OF THE DRAWINGS

FIG. 1 is a diagram illustrating the configuration of a power converter 1000 according to an embodiment.
FIG. 2 is a cross-sectional view of a power semiconductor device 100 according to an embodiment.
FIG. 3 is a cross-sectional view of a power semiconductor device 100 according to an embodiment.
FIG. 4 is a cross-sectional view of the power semiconductor device 102 according to the second embodiment.
FIGS. 5 to 11 are cross-sectional views of the manufacturing process of the power semiconductor device 100 according to an embodiment.

### DETAILED DESCRIPTION

Hereinafter, embodiments are described in detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

### (Embodiment)

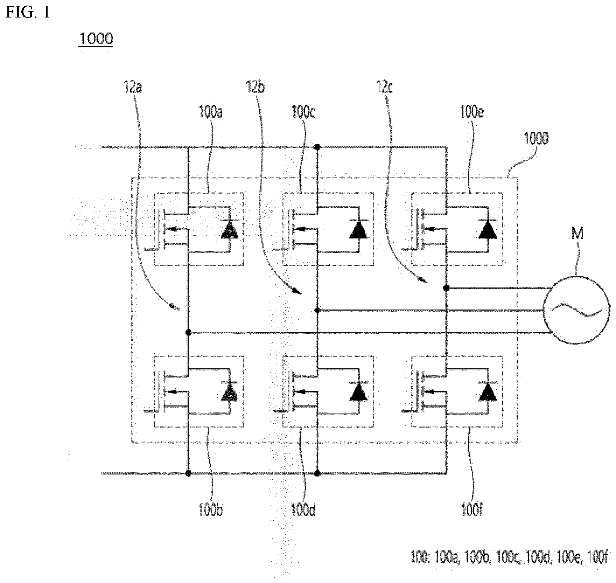

FIG. 1 is an exemplary configuration diagram of a power converter 1000 according to an embodiment.

The power converter 1000 according to the embodiment can receive DC power from a battery or fuel cell, convert it into AC power, and supply AC power to a predetermined load. For example, the power converter 1000 according to the embodiment can include an inverter, which receives DC power from a battery, converts DC power into 3-phase AC power, and supplies 3-phase AC power to a motor M. In certain aspects, motor M can provide power to electric vehicles or fuel cell vehicles.

The power converter 1000 according to the embodiment can include a power semiconductor device 100. The power semiconductor device 100 can be a MOSFET (Metal Oxide Semiconductor Field Effect Transistor), but is not limited thereto, and can include an IGBT (Insulated Gate Bipolar Transistor).

For example, the power converter 1000 can include a plurality of power semiconductor devices 100a, 100b, 100c, 100d, 100e, and 100f, and can include a plurality of diodes (not shown). Each of the plurality of diodes can be embedded in each of the power semiconductor devices 100a, 100b, 100c, 100d, 100e, and 100f in the form of an internal diode, but is not limited thereto, and can be disposed separately.

The embodiment can convert DC power to AC power through on-off control of a plurality of power semiconductor devices 100a to 100f. For instance, in the power converter 1000 according to embodiments, the first power semiconductor device 100a can be turned on and the second power semiconductor device 100b can be turned off in a first time period of one cycle to supply positive polarity power to the motor M. In addition, in the second time period of one cycle, the first power semiconductor device 100a can be turned off and the second power semiconductor device 100b can be turned on to supply negative polarity power to the motor M.

A group of power semiconductor devices disposed in series in a high voltage line and a low voltage line of an input side can be referred to as an arm. For example, the first power semiconductor device 100a and the second power semiconductor device 100b can constitute a first arm, and the third power semiconductor device 100c and the fourth power semiconductor device 100d can constitute a second arm. And the fifth power semiconductor device 100e and the sixth power semiconductor device 100f can constitute a third arm.

In the arm, an upper side power semiconductor device and a lower side power semiconductor device can be controlled not to turn on at the same time. For example, in the first arm, the first power semiconductor device 100a and the second power semiconductor device 100b do not simultaneously turn on, but can turn on and off alternately.

In some embodiments, each of the power semiconductor devices 100a to 100f can receive high power in an off state. For example, when the second power semiconductor device 100b is turned off while the first power semiconductor device 100a is turned on, the input voltage can be applied to the second power semiconductor device 100b as it is. The voltage input to the second power semiconductor device 100b can be a relatively high voltage, and a withstand voltage of each power semiconductor device 100a to 100f can be designed to have a high level to withstand such a high voltage.

Additionally, and in certain aspects, each of the power semiconductor devices 100a to 100f can conduct a high current in a turn on state. The motor M can be driven with a relatively high current, and this high current can be supplied to the motor M through a power semiconductor that is turned on.

A high voltage applied to each of the power semiconductor devices 100a to 100f can cause a high switching loss. A high current conducting the power semiconductor devices 100a to 100f can cause a high conduction loss. In order to dissipate heat generated by such switching loss or conduction loss, the power semiconductor devices 100a to 100f can be packaged as a power semiconductor module including a heat dissipation means.

In some embodiments, the power semiconductor device 100 can be a silicon carbide (SiC) power semiconductor device. In certain aspects, it can operate in a high-temperature, high-voltage environment, and can have a high switching speed and low switching loss.

In some embodiments, the power converter 1000 according to the embodiment can include a plurality of power semiconductor modules.

For example, the plurality of power semiconductor devices 100a to 100f shown in FIG. 1 can be packaged into one power semiconductor module, or the power semiconductor devices constituting each arm can be packaged into one power semiconductor module.

As another example, the first power semiconductor device 100a, the second power semiconductor device 100b, the third power semiconductor device 100c, the fourth power semiconductor device 100d, and the fifth power semiconductor device 100e and the sixth power semiconductor device 100f shown in FIG. 1 can be packaged into one power semiconductor module.

In addition, there can be additional power semiconductor devices disposed in parallel with each of the power semiconductor devices 100a to 100f to increase a current capacity. In this case, the number of power semiconductor devices included in the power semiconductor module can be greater than six.

The power converter 1000 according to embodiments can include a diode-type power semiconductor device in addition to the transistor-type power semiconductor devices 100a to 100f. For example, a first diode (not shown) can be disposed in parallel with the first power semiconductor device 100a, and a second diode (not shown) can be disposed in parallel with the second power semiconductor device 100b. Also, these diodes can be packaged together in one power semiconductor module. In addition, the diode can be disposed in the form of an internal diode in each power semiconductor device.

In some embodiments, the power semiconductor devices constituting each arm can be packaged into one power semiconductor module.

For example, the first power semiconductor device 100a and the second power semiconductor device 100b constituting the first arm can be packaged as a first power semiconductor module. The third power semiconductor device 100c and the fourth power semiconductor device 100d constituting the second arm can be packaged into a second power semiconductor module. And the fifth power semiconductor device 100e and the sixth power semiconductor device 100f constituting the third arm can be packaged into a third power semiconductor module.

In addition, there can be additional power semiconductor devices arranged in parallel with each power semiconductor device 100a to 100f to increase a current capacity. In this case, the number of power semiconductor devices included in each power semiconductor module can be more than two. Also, each arm can include a diode-type power semiconductor device (not shown) in addition to the transistor-type power semiconductor devices 100a to 100f, and these diodes can also be packaged together in one power semiconductor module. In addition, the diode can be disposed in a form of an internal diode in each power semiconductor device.

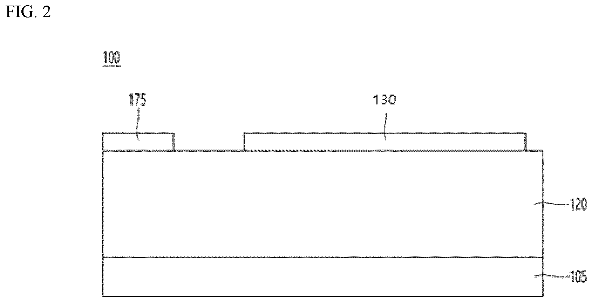

Next, FIG. 2 is a cross-sectional view of one of the power semiconductor devices 100 according to an embodiment.

The power semiconductor device 100 according to the embodiment can include a source electrode 130, a gate electrode 175 disposed on the upper side of a predetermined semiconductor epi layer 120, and a drain electrode 105 disposed below the semiconductor epi layer 120.

In the form of a MOSFET, the source electrode 130 or the gate electrode 175 can include an Al-based metal, The drain electrode 105 can include Ti/Ni/Ag metal including a Ti layer, a Ni layer, and an Ag layer, or NiV/Ag, V(vanadium)/Ni/Ag, etc., but is not limited thereto.

One of the technical objects of the embodiment is to prevent electric field concentration at the corners of the trench and prevent the problem of cell pitch reduction due to lateral straggling.

Hereinafter, a power semiconductor device 100 according to an embodiment for solving the above technical problems will be described.

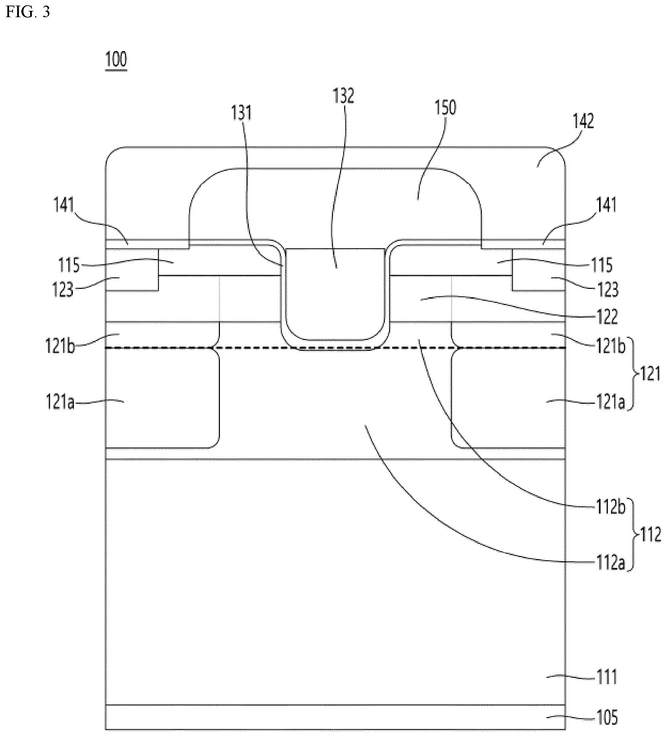

FIG. 3 is a cross-sectional view of the power semiconductor device 100 according to an embodiment.

First, referring to FIG. 3, the power semiconductor device 100 according to the embodiment can include at least one of drain electrode 105, substrate 111, epi layer 112 of first conductivity type, well 121 of second conductivity type, ion implantation region 122 of second conductivity type, a first conductive source region 115, a source contact region 141, a second conductive contact region 123, source electrode 142, gate insulating layer 131, gate 132, interlayer insulating layer 150.

The epi layer 112 of the first conductivity type can include a first epi layer 112a of the first conductivity type and a second epi layer 112b of the first conductivity type.

Additionally, the well 121 of the second conductivity type can include a first well 121a of the second conductivity type and a second well 121b of the second conductivity type.

The first conductivity type can be N-type, and the second conductivity type can be P-type, but are not limited thereto. The substrate 111 and the first conductive type epi layer 112 can include silicon carbide (SiC), but are not limited thereto.

Specifically, the power semiconductor device 100 according to the embodiment can include a substrate 111, a first epi layer 112a of a first conductivity type disposed on the substrate 111, a second epi layer 112b of the first conductivity type disposed on the first epi layer 112a of the first conductivity type.

In addition, the embodiment can include a first well 121a of a second conductivity type partially disposed in the first epi layer 112a of the first conductivity type and a second well 121b of a second conductivity type disposed in the second epi layer 112b of the first conductivity type.

In addition, the embodiment can include an ion implantation region 122 of the second conductivity type partially disposed in the second well 121b of the second conductivity type; and a source region 115 and a second conductivity type contact region 123 disposed on the second conductivity type ion implantation region 122.

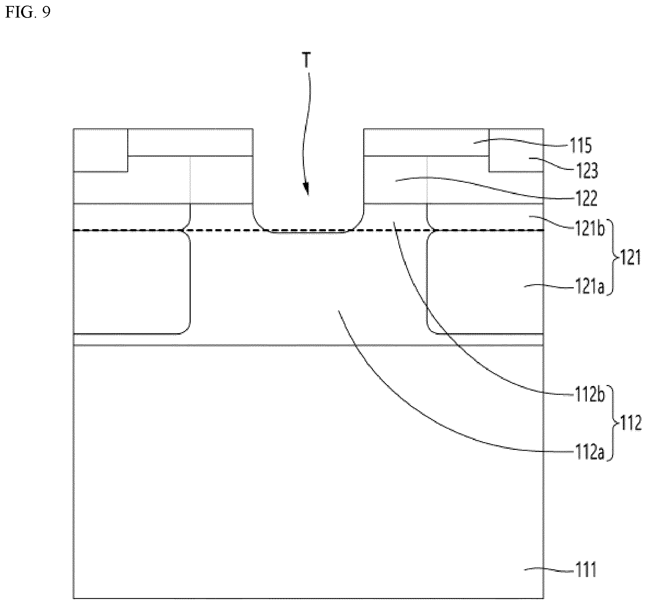

In addition, the embodiment can include a source electrode 142 disposed on the source region 115 and the second conductivity type contact region 123, a gate insulating layer 131 disposed on the bottom and sidewalls of the trench region T (refer to FIG. 9) from which a portion of the second epi layer 112b of the first conductivity type and the ion implantation region 122 of the second conductivity type is removed, a gate 132 disposed on the gate insulating layer 131, an interlayer insulating layer 150 disposed on the trench gate 132, and gate electrode (not shown) electrically connected to the trench gate 132.

According to the power semiconductor device, the power converter including the same, and the manufacturing method of the power semiconductor device according to the embodiment, the embodiment has the technical effect of preventing electric field concentration at the corner of the trench and preventing the problem of pitch reduction due to lateral straggling.

The lateral straggling may be an unintentional increase in ion implantation in the lateral direction. When lateral straggling occurs, there is a problem that Ron increases as the movement width of electrons narrows.

In order to solve this problem, the power semiconductor device 100 according to the embodiment can include a first epi layer 112a of a first conductivity type and a second epi layer 112b of a first conductivity type sequentially disposed on the substrate 111, and can include a first well 121a of the second conductivity type disposed on the first epi layer 112a of the first conductivity type, and a second well 121b of a second conductivity type disposed in the second epi layer 112b of the first conductivity type.

The power semiconductor device 100 according to the embodiment can be formed by ion implanting a first well 121a of the second conductivity type into the first epi layer 112a of the first conductivity type after growing the first epi layer 112a of the first conductivity type on the substrate 111. Thereafter, a second epi layer 112b of the first conductivity type can be grown on the first epi layer 112a of the first conductivity type, a second well 121b of the second conductivity type can be disposed in the second epi layer 112b of the first conductivity type by ion implantation.

The side surface of the first well 121a of the second conductivity type and the side surface of the second well 121b of the second conductivity type can be aligned upward on the substrate.

According to an embodiment, the second conductivity type well 121 is formed without using high-energy ion implantation, thereby preventing the problem of pitch reduction due to lateral straggling of the dopant, and at the same time, by forming the second well 121b of the second conductivity type in a region deeper than the trench gate 132 formed later, there is a technical effect of preventing destruction of the gate insulating layer by dispersing the electric field concentrated at the gate trench bottom corner.

In addition, the doping concentration of the first well 121a of the second conductivity type disposed on the first epi layer 112a of the first conductivity type of the embodiment can be higher than the doping concentration of the second well 121b of the second conductivity type disposed in the second epi layer 112b of the first conductivity type.

For example, according to the embodiment, there is a technical effect in that it is possible to implement a concentration gradient in which the doping concentration of the first well 121a of the second conductivity type formed below the trench gate 132 changes more abruptly than the doping concentration of the second well 121b of the second conductivity type formed adjacent to the trench gate 132.

For example, the doping concentration of the first well 121a of the second conductivity type can be 2×10¹⁷ to 2×10¹⁹/cm³, and the doping concentration of the second well 121b of the second conductivity type can be 1×10¹⁶ to 1×10¹⁷/cm³, but is not limited thereto.

According to the embodiment, as the doping concentration of the first well 121a of the second conductivity type formed below the trench gate 132 is formed to be higher than the doping concentration of the second well 121b of the second conductivity type, since there is an effect of expanding the depletion layer in the direction of the substrate 111, there is a technical effect of increasing the breakdown voltage. In addition, according to the embodiment, the doping concentration of the second well 121b of the second conductivity type formed around the trench gate 132 is formed lower than the doping concentration of the first well 121a of the second conductivity type, there is a complex technical effect of reducing the threshold voltage and increasing current density.

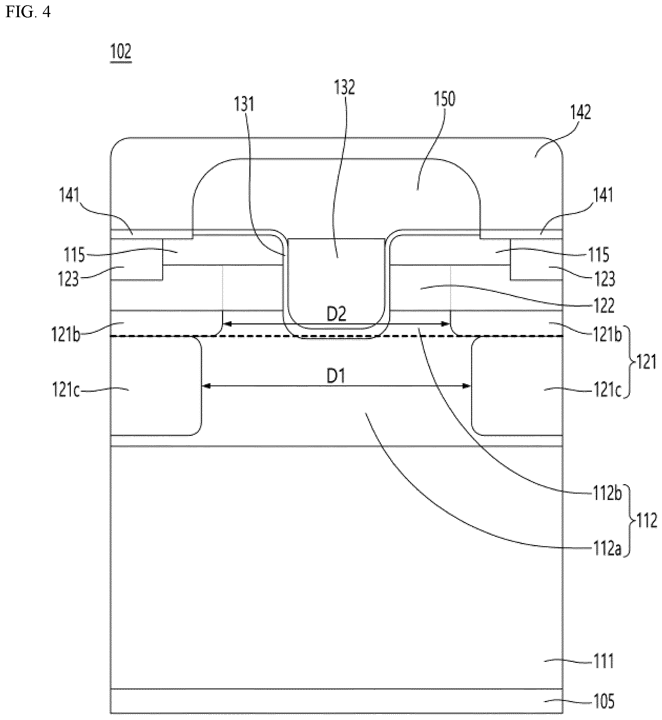

Next, FIG. 4 is a cross-sectional view of the power semiconductor device 102 according to the second embodiment.

The second embodiment can adopt the technical features of the previously described embodiment, and the description will now focus on the features of the second embodiment.

Referring to FIG. 4, in the power semiconductor device 102 according to the second embodiment, the first well 121 of the second conductivity type can include a third well 121c of a second conductivity type disposed on the first epi layer 112a of the first conductivity type and a second well 121b of the second conductivity type disposed on the second epi layer 112b of the first conductivity type.

According to the second embodiment, the third well 121c of the second conductivity type can be disposed in the first epi layer 112a of the first conductivity type by ion implantation. Thereafter, the second well 121b of the second conductivity type can be formed by ion implantation in the second epi layer 112b of the first conductivity type grown on the first epi layer 112a of the first conductivity type.

At this time, the first distance D1 between the third wells 121c of the second conductivity type disposed on the first epi layer 112a of the first conductivity type can be longer than the second distance D1 between the second wells 121b of the second conductivity type disposed on the second epi layer 112b of the first conductivity type.

According to the second embodiment, by controlling the first distance D 1 between the third wells 121c of the second conductivity type formed below the trench gate 132 to be longer than the second distance D1 between the second wells 121b of the second conductivity type formed around the trench gate 132, there is a special technical effect of reducing Ron by widening the movement range of electrons.

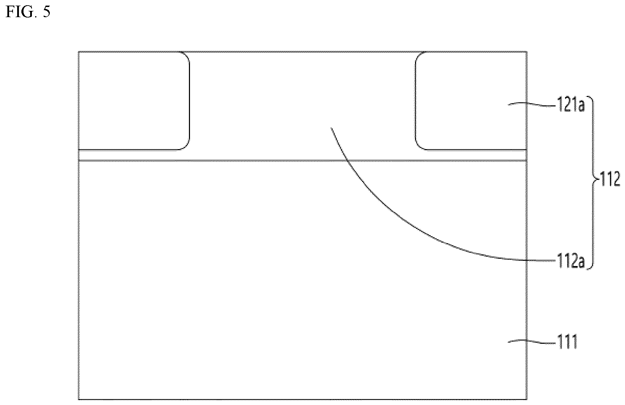

Next, the manufacturing process of the power semiconductor device 100 according to the embodiment shown in FIG. 3 will be described with reference to FIGS. 5 to 11.

First, referring to FIG. 5, a first epi layer 112a of the first conductivity type can be grown on the substrate 111.

The first epi layer 112a of the first conductivity type can include a first conductivity type buffer layer (not shown) and a first conductivity type drift layer (not shown).

The substrate 111 and the first epi layer 112a of the first conductivity type can include, but are not limited to, a 4H-SiC material. For example, the substrate 111 and the first epi layer 112a of the first conductivity type can include 3C-SiC or 6H-SiC.

Next, the first well 121a of the second conductivity type can be disposed in the first epi layer 112a of the first conductivity type by ion implantation.

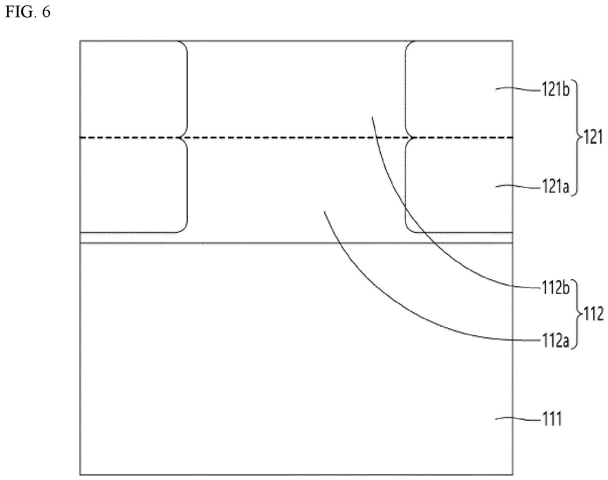

Next, referring to FIG. 6, a second epi layer 112b of the first conductivity type can be grown on the first epi layer 112a of the first conductivity type. Thereafter, a second well 121b of the second conductivity type can be disposed in the second epi layer 112b of the first conductivity type by ion implantation.

For example, the first well 121a of the second conductivity type and the second well 121b of the second conductivity type can be formed by forming a hard mask pattern (not shown) and ion implanting the hard mask pattern as a mask. The first well 121a of the second conductivity type and the second well 121b of the second conductivity type can be P-type bodies, but are not limited thereto.

The hard mask pattern can include a polysilicon pattern and an oxide pattern, but is not limited thereto.

A P-type dopant can be ion-implanted into the first well 121a of the second conductivity type and the second well 121b of the second conductivity type. For example, Al or boron can be injected, but it is not limited thereto.

According to an embodiment, the second conductivity type well 121 can be formed without using high-energy ion implantation, thereby preventing the problem of pitch reduction due to lateral straggling of the dopant, and at the same time, by forming the second well 121b of the second conductivity type in a region deeper than the trench gate 132 formed later, there is a technical effect of preventing destruction of the gate insulating layer by dispersing the electric field concentrated at the gate trench bottom corner.

In addition, the doping concentration of the first well 121a of the second conductivity type disposed on the first epi layer 112a of the first conductivity type of the embodiment can be higher than the doping concentration of the second well 121b of the second conductivity type disposed in the second epi layer 112b of the first conductivity type.

For example, according to the embodiment, there is a technical effect that it is possible to implement a concentration gradient in which the doping concentration of the first well 121a of the second conductivity type formed below the trench gate 132 changes more abruptly than the doping concentration of the second well 121b of the second conductivity type formed adjacent to the trench gate 132.

For example, the doping concentration of the first well 121a of the second conductivity type can be 2×10¹⁷~2×10¹⁹/cm³, and the doping concentration of the second well 121b of second conductivity type can be 1×10¹⁶ to 1×10¹⁷/cm³, but is not limited thereto.

According to the embodiment, as the doping concentration of the first well 121a of the second conductivity type formed below the trench gate 132 is formed to be higher than the doping concentration of the second well 121b of the second conductivity type, since there is an effect of expanding the depletion layer in the direction of the substrate 111, there is a technical effect of increasing the breakdown voltage. In addition, according to the embodiment, the doping concentration of the second well 121b of the second conductivity type formed around the trench gate 132 is formed lower than the doping concentration of the first well 121a of the second conductivity type, there is a complex technical effect of reducing the threshold voltage and increasing current density.

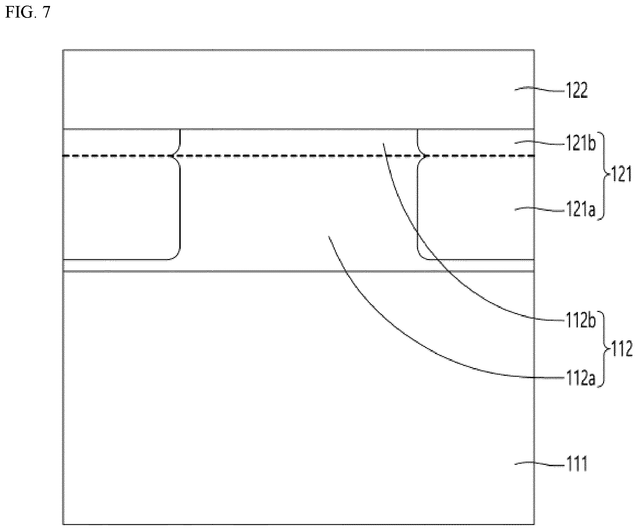

Next, referring to FIG. 7, the second conductivity type ion implantation region 122 can be formed by implanting Al or boron into the second epi layer 112b of the first conductivity type and the second well 121b of the second conductivity type.

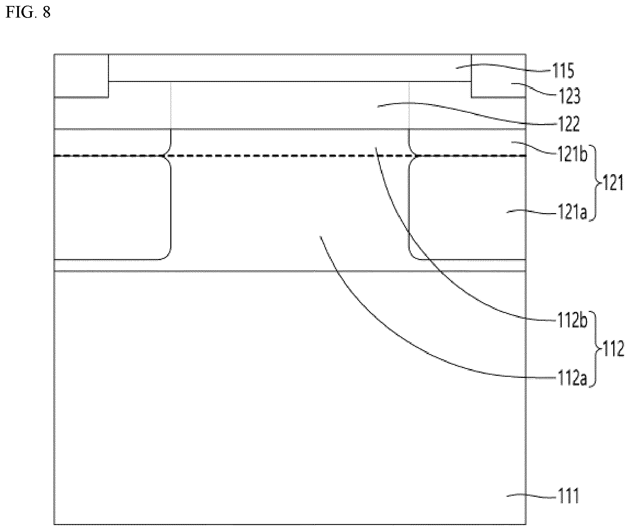

Next, referring to FIG. 8, the first conductive type source region 115 can be formed by implanting ions into the second conductive type ion implantation region 122 using an ion implantation mask with a second hard mask pattern (not shown). For example, the first conductivity type source region 115 can be formed by ion implanting an N-type dopant, such as nitrogen or phosphorus, at a concentration of about 1×10¹⁸ cm⁻³ to about 7×10¹⁹ cm⁻³ using a self-alignment method.

Additionally, the second conductive type contact region 123 can be formed using the third hard mask pattern (not shown) as an ion implantation mask. The second conductive type contact region 123 can function to maintain the zero potential of the second conductive ion implantation region 122 and can function as a body diode.

Next, referring to FIG. 9, a trench region T can be formed by partially removing a first conductive type source region 115, a second conductive type ion implantation region 122, and a second epi layer 112b of the first conductivity type using a predetermined hard mask pattern (not shown) as a mask.

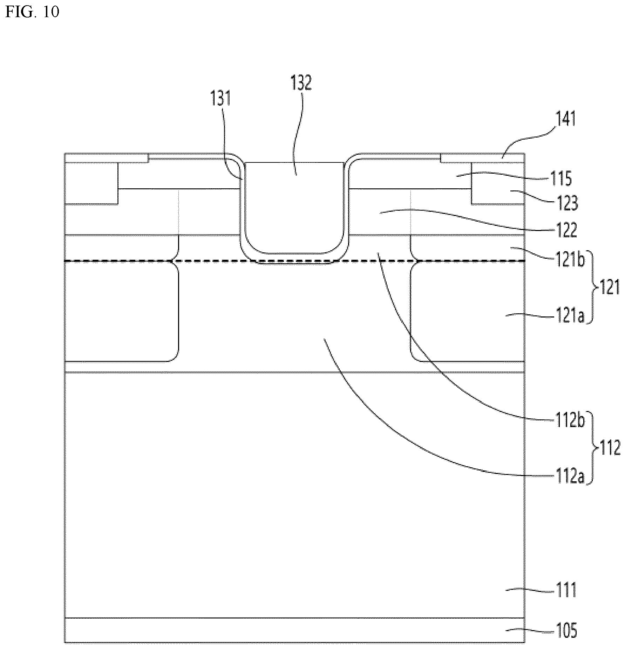

Next, referring to FIG. 10, a gate insulating layer 131 can be disposed in the trench region T, and a trench gate 132 can be disposed on the gate insulating layer 131.

The gate insulating layer 131 can be a thermal oxidation film or a deposited oxide film using LPCVD, but is not limited thereto. The trench gate 132 can be formed of polysilicon, but is not limited thereto.

Afterwards, the source contact 141 can be formed. For example, the source contact 141 can be formed using Ti or Ni, but is not limited thereto.

Additionally, the drain electrode 105 can be disposed on the substrate 111 using Ti/Al.

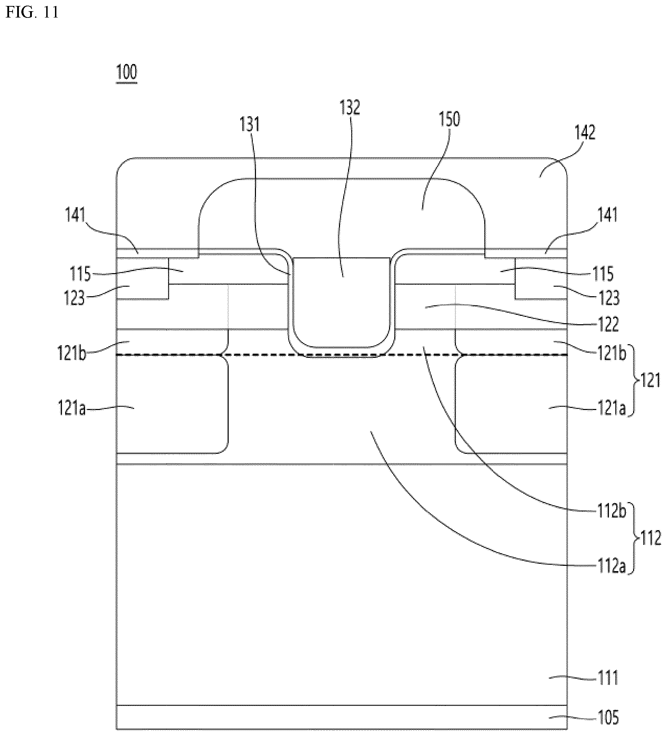

Next, referring to FIG. 11, an interlayer insulating layer 150 can be disposed on the trench gate 132 and the gate insulating layer 131, and a source electrode 142 can be disposed on the interlayer insulating layer 150 and the source contact 141.

The interlayer insulating layer 150 can be formed of an oxide film or a nitride film, but is not limited thereto.

The source electrode 142 can be formed of Al, but is not limited thereto. Additionally, the source electrode 142 can further include a barrier metal layer.

According to the power semiconductor device, the power converter including the same, and the manufacturing method of the power semiconductor device according to the embodiment, there are technical effects in that the problem of pitch reduction due to lateral straggling can be prevented while preventing electric field concentration at the corner of the trench.

For example, the power semiconductor device 100 according to the embodiment can form the second conductivity type well 121 without using high-energy ion implantation. Accordingly, the problem of pitch reduction due to lateral straggling of the dopant can be prevented, and the second well 121b of the second conductivity type can be disposed in a region deeper than the trench. As a result, the embodiment enables dispersion of the electric field concentrated at the bottom corner of the gate trench, which has the technical effect of preventing destruction of the gate insulating layer.

Also, according to the embodiment, the doping concentration of the first well 121a of the second conductivity type formed below the trench gate 132 may be formed to be higher than the doping concentration of the second well 121b of the second conductivity type. Accordingly, since the depletion layer is expanded in the direction of the substrate 111, there is a technical effect of increasing the breakdown voltage. In addition, according to the embodiment, the doping concentration of the second well 121b of the second conductivity type formed around the trench gate 132 is lower than the doping concentration of the first well 121a of the second conductivity type, so that there is a complex technical effect of decreasing the threshold voltage and increasing current density.

Also, according to the second embodiment, the first distance D1 between the third wells 121c of the second conductivity type disposed on the first epi layer 112a of the first conductivity type may be longer than the second distance D2 between the second wells 121b of the second conductivity type disposed in the second epi layer 112b of the first conductivity type.

Also, according to the second embodiment, the first distance D1 between the third wells 121c of the second conductivity type disposed on the lower side of the trench gate 132 can be controlled to be longer than the second distance D2 between the second wells 121b of the second conductivity type formed around the trench gate 132. Accordingly, there is a special technical effect of reducing Ron by widening the movement range of electrons.

In the above, the present invention has been described with reference to embodiments, those skilled in the art will easily understand that various modifications and changes can be made to the present invention without departing from the scope of the present invention as set forth in the claims below.

## Claims

1. A power semiconductor device, comprising:
a substrate;
a first epi layer of a first conductivity type disposed on the substrate;
a second epi layer of the first conductivity type disposed on the first epi layer of the first conductivity type;
a first well of a second conductivity type partially disposed in the first epi layer of the first conductivity type;
a second well of the second conductivity type disposed on the second epi layer of the first conductivity type;
an ion implantation region of the second conductivity type and a source region disposed in the second well of the second conductivity type;
a source electrode disposed on the source region;
a gate insulating layer in a trench region, wherein the trench region is disposed in a portion of the ion implantation region of the second conductivity type and the second epi layer of the first conductivity type are removed;
a trench gate disposed on the gate insulating layer;
an interlayer insulating layer disposed on the trench gate, and
a gate electrode electrically connected to the trench gate.

2. The power semiconductor device according to claim 1, wherein the side surface of the first well of the second conductivity type and the side surface of the second well of the second conductivity type are aligned upward on the substrate.

3. The power semiconductor device according to any one of claims 1 or 2, wherein a doping concentration of the first well of the second conductivity type disposed in the first epi layer of the first conductivity type is different from that of the second well of the second conductivity type disposed in the second epi layer of the first conductivity type.

4. The power semiconductor device according to claim 3, wherein the doping concentration of the first well of the second conductivity type disposed in the first epi layer of the first conductivity type is higher than the doping concentration of the second well of the second conductivity type disposed in the second epi layer of the first conductivity type.

5. The power semiconductor device according to claim 3 or 4, wherein a gradient of doping concentration of the first well of the second conductivity type below the trench gate is configured to change more abruptly than that of doping concentration of the second well of the second conductivity type formed adjacent to the trench gate.

6. The power semiconductor device according to any one of the preceding claims, the doping concentration of the first well of the second conductivity type is 2×10¹⁷~2×10¹⁹/cm³, and/or wherein the doping concentration of the second well of the second conductivity type is 1×10¹⁶~1×10¹⁷/cm³.

7. The power semiconductor device according to any one of claims 1 to 6, wherein an interface is disposed between the first well of the second conductivity type and the second well of the second conductivity type in the first epi layer of the first conductivity type.

8. The power semiconductor device according to claim 7, wherein the interface between the first well of the second conductivity type and the second well of the second conductivity type is disposed at substantially the same position as a lower side of the trench gate.

9. The power semiconductor device according to any one of the preceding claims, wherein a first distance between the first wells of the second conductivity type in the first epi layer of the first conductivity type and a second distance between the second wells of the second conductivity type in the second epi layer of the first conductivity type are different from each other.

10. The power semiconductor device according to claim 9, wherein the first distance between the first wells of the second conductivity type in the first epi layer of the first conductivity type is greater than the second distance between the second wells of the second conductivity type in the second epi layer of the first conductivity type.

11. The power semiconductor device according to any one of the preceding claims, wherein a portion of a lower edge of the second well of the second conductivity type is configured not to vertically overlap with the first well of the second conductivity type.

12. The power semiconductor device according to any one of claims 1 to 11, wherein the first well of the second conductivity type is disposed below the trench gate, and wherein the second well of the second conductivity type is disposed in a horizontal position of the trench gate.

13. The power semiconductor device according to any one of claims 1 to 12, wherein a depth of the second well of the second conductivity type is different from that of the first well of the second conductivity type.

14. The power semiconductor device according to claim 13, wherein the depth of the second well of the second conductivity type is lower than that of the first well of the second conductivity type.

15. A power converter comprising the power semiconductor device of according to any one of claims 1 to 14.
